# EUROPEAN PATENT APPLICATION

(11) **EP 3 499 728 A1**
(43) Date of publication of application: **19.06.2019**
(21) Application number: 17207392.6
(22) Date of filing: 14.12.2017
(51) Int. Cl.: H03M 1/68, H03M 1/74, H03M 1/06, H03F 3/21, H03F 3/217

(54) **DIGITAL POWER AMPLIFICATION CIRCUIT**

(71) Applicant: Stichting IMEC Nederland, 5656 AE Eindhoven (NL)
(72) Inventor: Ba, Ao, 3001 Leuven (BE)
(74) Representative: Patent Department IMEC

(57) **Abstract**

The present invention relates to a digital power amplification circuit comprising :
- a decoding block (3) arranged for receiving a first stream of digital codes and for deriving from the first stream a second stream of digital codes and comprising decoding means for decoding the digital codes of the first and the second stream at a first clock rate,
- a main digital power amplifier (5) arranged for receiving said decoded digital codes of the first stream,
- upsampling means (4) for upsampling the decoded digital codes of the second stream to a second clock rate higher than said first clock rate,
- an auxiliary digital power amplifier (6) arranged for receiving said decoded digital codes of the second stream upsampled to the second clock rate,
- summing means for summing a main output signal of said main digital power amplifier and an auxiliary output signal of said auxiliary digital power amplifier.

## Description

### Field of the invention

The present invention is generally related to the field of RF Digital-to-Analog Converters (RF-DAC) and digital power amplifiers.

### Background of the invention

Nanoscale CMOS has brought many high speed applications to the consumer thanks to the computing power that can be squeezed into modern signal processors. Unfortunately, the intrinsic analog properties of CMOS transistors do not follow the improvements of their digital counterparts. CMOS transistor parameters like output impedance, supply versus threshold ratio or intrinsic gain typically worsen with the advance of the CMOS technological nodes.

One example of an important application field relates to digital radio transmitters. Modern communication schemes impose tough requirements on radio transmitters. Transmitters operating at RF have to combine hard requirements such as RF bandwidth, linearity and out-of-band noise while maintaining a high efficiency. As a result, the porting of an analog RF transmitter from one technological node to another is complicated and thus slow and costly. Thus, transmitters need to have the least possible analog circuitry. In addition, it is desirable for radio transmitters to be easily scalable with the advancement of CMOS technologies.

To address the problem of analog RF transmitters, a new family of RF transmitters, digital transmitters (also referred to as RF-DACs or Direct Digital RF Modulators, DDRM), has been adopted. The digital transmitters feature a predominantly digital circuitry which is better suited for advanced CMOS technology and which scales much better with the various CMOS technological nodes. In contrast to their analog counterpart, the performance of digital transmitters intrinsically improves with the scaling of CMOS technology.

The first digital transmitters were based on a polar architecture, in which a phase modulated local oscillator (LO) signal is fed to a multitude of DDRM units and amplitude modulation is performed by enabling or disabling (switching on or off) these DDRM unit amplifiers and then combining their output power to form a modulated RF analog signal. Later, Cartesian DDRM architectures consisting of two such digital amplitude modulators, for modulating the in-phase (I) and the quadrature (Q) signals with the respective LO phases, were also adopted in digital transmitters. The outputs of these two digital amplitude modulators are summed before being fed to the antenna for transmission.

Similar to a DAC, a digital power amplifier transforms digital input amplitude code into amplitude-modulated RF carrier. The digital-to-analog conversion unavoidably generates clock aliasing at multiples of the clock frequency.

In order to reduce the effect of aliasing the sampling rate needs to be increased. To keep the amount of quantization noise under control it is needed to increase the accuracy. Although the total amount of quantization noise only relates to the digital-to-analog resolution/accuracy, the increase of sampling rate spreads the quantization noise into a wider bandwidth, so the quantization noise density is reduced.

Application US2010/135368 is concerned with these problems. A discrete-time input sample stream is upsampled/interpolated with time alignment utilizing the addition of randomized high frequency noise. The upsampling mechanism implements a second order interpolator. It takes the derivative of the discrete-time input sample stream, thereby effectively providing another order of interpolation over a conventional interpolator. Before outputting the interpolated signal, an integrator takes the integral of the interpolated samples. Any processing performed between the derivative and integrator blocks effectively provides an additional order of interpolation. High frequency noise (i.e. dithering) is added to the differentiated samples in order to eliminate the spectral regrowth spurs that would otherwise appear in the output after rounding. Delay alignment is performed on the differentiated samples in order to time align both phase/frequency and amplitude samples that are processed on different paths.

In US7668249 a digital quadrature rate converter and an oversampling interpolator are presented for a DDRM. Digital quadrature modulation data is received at one clock rate and oversampled digital quadrature modulation data is provided at a higher clock rate. Rate conversion and oversampled interpolation are used to accommodate systems with multiple clock frequencies and to generate modulation signals with low distortion. In this cascaded multi-rate approach all data is upsampled to the highest clock frequency.

The above-mentioned solutions finally end up with upsampling all data to the highest clock frequency at the cost of higher power consumption for the digital circuits.

Hence, there is a need for a circuit with enhanced out-of-band spectral purity wherein these drawbacks are reduced or overcome.

### Summary of the invention

It is an object of embodiments of the present invention to provide for a digital power amplification circuit wherein out-of-band alias tones are reduced, while remaining power efficient.

The above objective is accomplished by the solution according to the present invention.

In a first aspect the invention relates to a digital power amplification circuit comprising :
- decoding block arranged for receiving a first stream of digital codes and for deriving from the first stream a second stream of digital codes and comprising decoding means for decoding said digital codes of said first and said second stream at a first clock rate,
- a main digital power amplifier arranged for receiving said decoded digital codes of said first stream,
- upsampling means for upsampling the decoded digital codes of the second stream to a second clock rate higher than the first clock rate,
- an auxiliary digital power amplifier arranged for receiving said decoded digital codes of said second stream upsampled to the second clock rate,
- summing means for summing a main output signal of said main digital power amplifier and an auxiliary output signal of said auxiliary digital power amplifier.

The proposed solution indeed allows for reducing the out-of-band spectral emissions. By providing at least one auxiliary digital power amplifier arranged for operating at a higher clock rate than the main digital power amplifier it is possible to obtain a summed signal at the output.

In preferred embodiments the second stream of digital codes is derived from the first stream of digital codes by making a difference between the first stream and a delayed version of the first stream. In one embodiment the second stream is obtained by making the difference of the first stream with said first stream delayed over one sample.

Preferably the digital power amplification circuit comprises means for delaying the first stream of digital codes and subtracting means for determining the difference between the first stream and the delayed version of the first stream.

In preferred embodiments the auxiliary digital power amplifier has a higher resolution than the main digital power amplifier.

In embodiments the first clock rate and the second clock rate are derived from a same clock. Advantageously said same clock is comprised in the digital power amplification circuit.

In one embodiment the digital codes comprise amplitude information of the summed main output signal and auxiliary output signal.

In other embodiments the digital power amplification circuit comprises a plurality of upsampling means and a plurality of auxiliary digital power amplifiers. Advantageously each upsampling means is operable at its own upsampling factor.

In a preferred embodiment the digital codes modulate a clock signal comprising phase information.

In another aspect the invention relates to a radio device comprising a digital power amplifier as previously described.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates a generic scheme of an embodiment of the digital power amplifier circuit according to the invention.
Fig.2 illustrates the effect of having the auxiliary digital power amplifier operating at a higher clock rate than the main digital power amplifier.
Fig.3 illustrates the beneficial effect of the auxiliary DPA on the first alias tone.
Fig.4 illustrates an embodiment of the digital power amplifier circuit according to the invention comprising a plurality of auxiliary DPAs and a plurality of upsamplers.
Fig.5 illustrates an embodiment of a radio device comprising an embodiment of the digital power amplifier circuit of this invention.
Fig.6 illustrates a detailed implementation of the digital power amplifier and the upsampler inside the dotted line in Fig.5.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention presents a digital power amplification circuit designed to keep out-of-band emissions at a reduced level so that out-of-band emission requirements imposed by e.g. an IEEE 802.11g mask can be met.

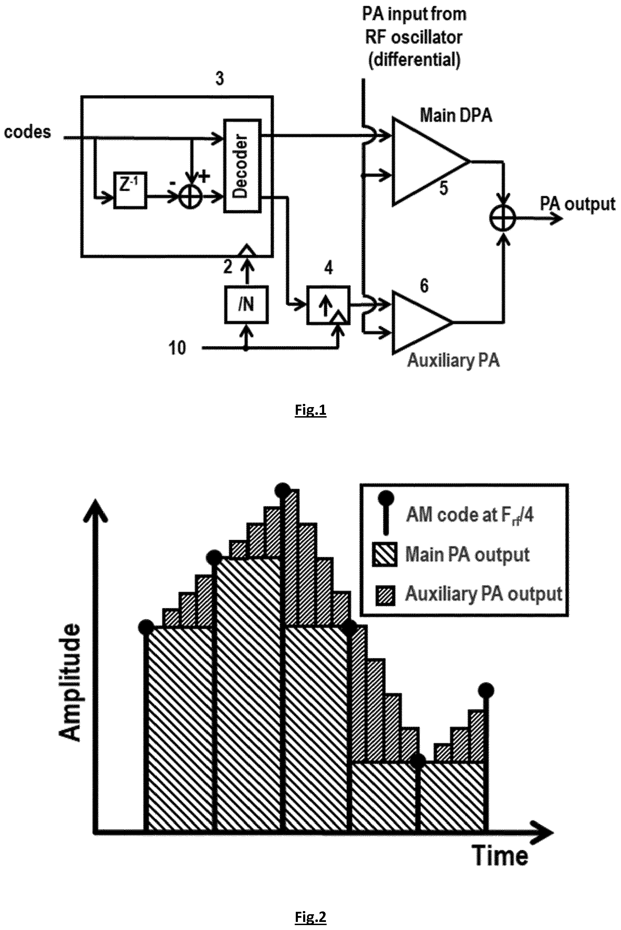

A basic scheme of the proposed solution is illustrated in Fig.1. In the decoding block (3) one receives a stream of digital codes. Two parallel paths towards the actual decoder are provided : one direct path and one path comprising delay means for delaying the received stream over a given number of samples and subtraction means for making a difference between the received stream and its delayed version. This difference is next also applied to the decoder. Both the received stream of digital codes and its delayed version are decoded at a first clock rate.

The stream of decoded digital codes along the direct path is applied to a main digital power amplifier (5). The stream of decoded codes obtained from the difference of the applied stream and a delayed version thereof, is upsampled to a second clock rate (4) higher than the first clock rate (2) and then fed to an auxiliary digital power amplifier (DPA) (6). The output signals of the main DPA and the auxiliary DPA are then summed to obtain the resulting power amplifier output signal.

In summary, the circuit of this invention comprises a decoding block (3) (for example, a look-up table) that generates the input codes based on the originally received codes, e.g. AM codes. The main DPA (5) receives the input codes that were decoded at a first, low clock rate. Hence, the main DPA has a low resolution and a low clock rate. The auxiliary DPA (6) receives a stream of codes derived from the difference between the received stream and a delayed version thereof. This stream of 'differences' is however first upsampled to a higher rate than the first clock rate and only then applied to the auxiliary DPA, which has a high resolution and a high clock rate.

In the embodiment shown in Fig.1 the first (low) and second (high) clock rate are derived from a same clock (10). As illustrated in Fig.1 the clock provides in this particular example the high clock rate. The low clock rate is obtained by dividing that high clock rate by an integer value N. Other implementations are readily available. In other embodiments the clock rates are derived from different clocks.

The delay over which the stream is delayed when deriving the difference between the applied stream and the delayed stream, can be configured. In a preferred embodiment the delayed stream is delayed over a single sample with respect to the received stream of digital codes .

The principle on which the proposed approach is based, is illustrated in Fig.2. The figure shows the codes (AM codes in this example) and the output signal of the main DPA. Both are at the same low clock rate. Based on the received digital codes, the main DPA produces the lower one of two adjacent codes. The auxiliary DPA receives the difference codes at a higher rate, in this example four times higher, than the rate at which the main DPA receives its inputs and produces small pulses at a four times higher rate, so filling the gaps and smoothing the amplitude transitions.

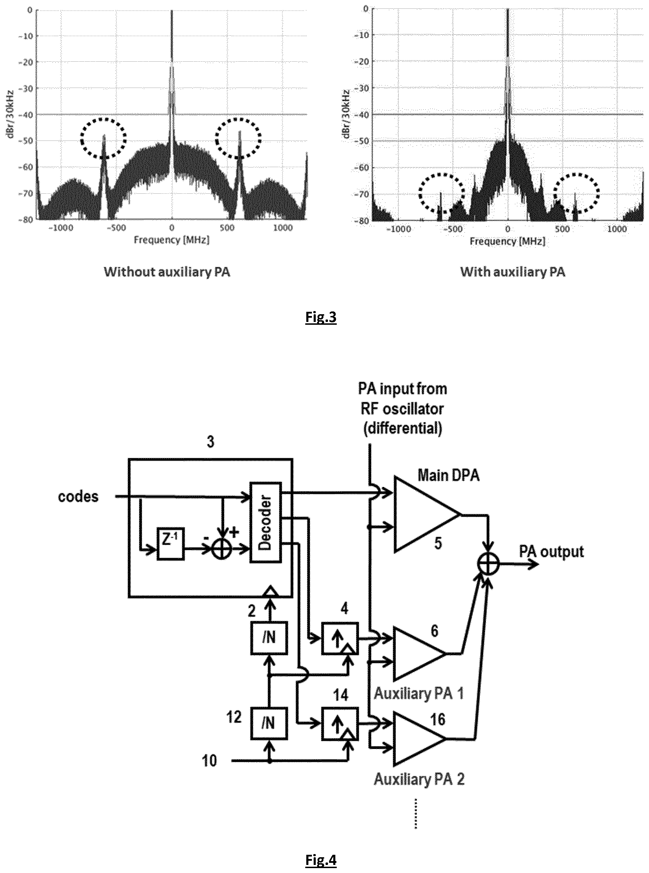

To illustrate the effect of the auxiliary at higher resolution and higher clock rate Fig.3 shows some simulation results. At the left side of the figure a conventional DPA is used, i.e. without auxiliary DPA. By providing the auxiliary DPA as set out above the amplitude level of the two alias tones indicated by a circle in the figure, can be suppressed by about 20 dB.

The embodiment of the digital amplifier circuit shown in Fig.4 comprises a plurality of auxiliary DPAs and a plurality of upsampling means. In the example auxiliary DPA1 (6) receives its input codes at a rate N times higher than the rate at which the first stream of digital codes is decoded. The other auxiliary digital power amplifier DPA2 (16) operates at a rate N² times higher than the lowest clock rate. As in Fig.1 the clock (10) operates at the highest rate needed and portions thereof are used in the various stages of the circuit. It is repeated once again that there are obviously alternatives available to this approach.

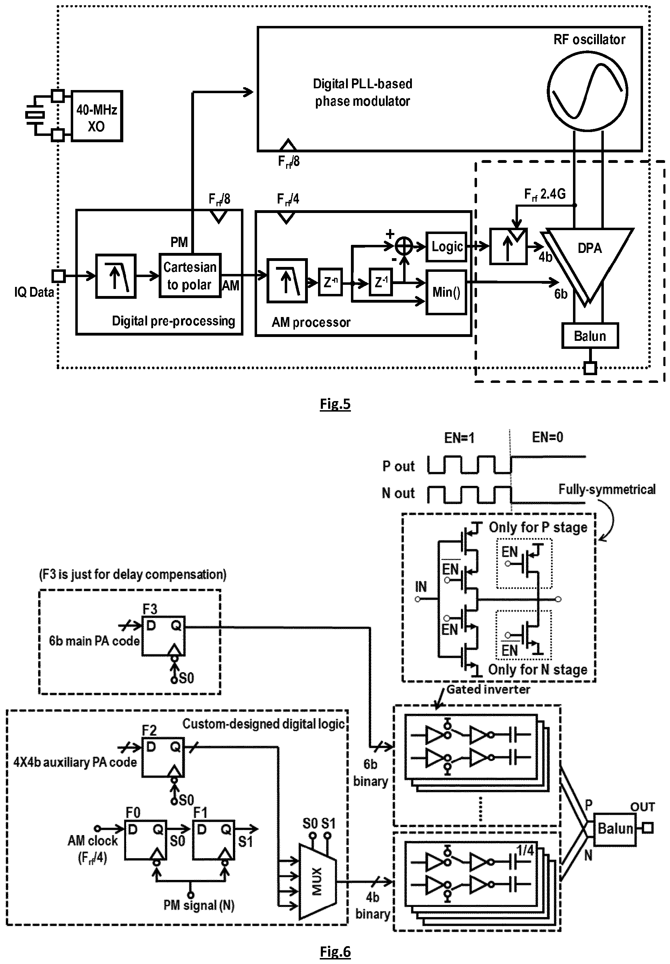

In one aspect the invention relates to a radio device comprising a digital power amplifier as previously described to suppress out-of-band alias tones. Fig.5 shows an embodiment of such a radio device wherein said DPA circuit is used for out-of-band AM alias suppression.

The digital pre-processing block converts the original IQ data into amplitude and phase data. The digital PLL (Phase Locked Loop) based phase modulator modulates the phase of the RF oscillator output in accordance with the phase data. The differential output of the RF oscillator is thus a phase-modulated RF carrier for the digital power amplifier.

The 40MHz crystal oscillator (XO) provides the reference clock for the digital PLL which outputs a 2.4GHz reference clock signal, F_{rf}. The 2.4GHz RF frequency F_{rf} is divided down to F_{rf}/8 (300MHz) and F_{rf}/4 (600MHz) inside the PLL. The F_{rf}/8 clock is used for the digital preprocessing block and the PLL-based phase modulator and the F_{rf}/4 clock is used for the AM processor. Only the data stream for the 4 bit auxiliary DPA is upsampled to the clock frequency F_{rf}. Operating the AM and PM processing blocks with the right clock rate in combination with the above-presented power efficient approach with the multiple PAs allows achieving a very power efficient radio device.

The AM processor is equivalent to the decoding block (3) in Fig.1, plus some additional functions for this particular radio. In the AM processor the AM data stream from the pre-processing block is first upsampled to F_{rf}/4 clock rate and then filtered. In addition, in block Z⁻ⁿ the delay between the AM path and the PM path is adjusted. The decoder of the block (3) in Fig.1 is here implemented as a "min()" function for the first data stream (to the main DPA) and a look-up table (shown as "Logic") for the second data stream (to the auxiliary DPA). This implementation is a very efficient way to obtain the function as illustrated in Fig.2.

An exploded view of the part in dashed line of Fig.5 is given in Fig.6. The flip-flop F3 compensates any remaining delay difference between the first and second data streams being fed to the main and the auxiliary DPA.

The wide-band operation of the digital transmitter puts strict requirements on the AM path, especially for suppressing out-of-band spurs. In a conventional architecture the digital PAs rely on *sinc* filtering originating from the digital-to-analog conversion to suppress clock aliases. Although the clock aliases can also be reduced by pushing the final oversampling rate to F_{rf}, it dramatically raises the total power consumption. Therefore the above-presented power-efficient approach with multiple PAs working at multiple rates is here employed.

A main 6bit power amplifier generates the minimal required amplitude based on the AM data at F_{rf}/4 rate and an auxiliary 4bit power amplifier smooths the amplitude transition with finer resolution at F_{rf} rate. In this case the AM modulation is split into a low-resolution low-rate modulation for power delivery and a high-resolution high-rate modulation for pulse shaping as illustrated in Fig.2. The look-up table (shown as "Logic" in Fig.5) in the AM processor synthesized at F_{rf}/4 rate generates 4X4bit control codes for the auxiliary PA each time (as each control code is 4bit, so 4X4bit auxiliary AM codes) and then is retimed to the correct sequence at F_{rf} rate by the custom-designed digital logic, thereby upsampling the second AM data steam to the F_{rf} clock domain. In the custom-designed digital logic this is performed by the flip flop F2. Flip flops F0 and F1 generate the control signal for the MUX, which then selects the corresponding 4bit AM code to be fed to the auxiliary PA at F_{rf} rate.

The main PA comprises 6 PA unit cells each receiving a corresponding bit from the 6bit code. Similarly, the auxiliary PA comprises 4 PA unit cells each receiving a corresponding bit from the 4bit code. The implementation of the main PA unit cell is the same as the auxiliary PA unit cell, except that the size of the auxiliary PA unit cell is 4 times smaller.

The PAs are implemented in a differential topology, the gated inverters for the differential stages P and N are implemented differently as shown in Fig. 6. The gated inverter of each PA unit is taped to VDD or VSS in the off mode (EN=0) for the P and N stages, respectively. So the rising and falling edges of the P and N stages are fully symmetrical. Such a fully-differential operation guarantees a better PA linearity. Finally, the balun sums the main and the auxiliary PA(s) output signals and converts the differential output to a single-ended output.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Digital power amplification circuit comprising :
- a decoding block (3) arranged for receiving a first stream of digital codes and for deriving from said first stream a second stream of digital codes and comprising decoding means for decoding said digital codes of said first and said second stream at a first clock rate,
- a main digital power amplifier (5) arranged for receiving said decoded digital codes of said first stream,
- upsampling means (4) for upsampling said decoded digital codes of said second stream to a second clock rate higher than said first clock rate,
- an auxiliary digital power amplifier (6) arranged for receiving said decoded digital codes of said second stream upsampled to said second clock rate,
- summing means for summing a main output signal of said main digital power amplifier and an auxiliary output signal of said auxiliary digital power amplifier.

2. Digital power amplification circuit as in claim 1, wherein said second stream of digital codes is derived from said first stream by making a difference between said first stream and a delayed version of said first stream.

3. Digital power amplification circuit as in claim 2, comprising means for delaying said first stream of digital codes and subtracting means for determining said difference between said first stream and said delayed version of said first stream.

4. Digital power amplification circuit as in any of claims 1 to 3, wherein said auxiliary digital power amplifier (6) has a higher resolution than said main digital power amplifier.

5. Digital power amplification circuit as in any of claims 1 to 3, wherein said first clock rate and said second clock rate are derived from a same clock (10).

6. Digital power amplification circuit as in claim 5, comprising said same clock.

7. Digital power amplification circuit as in as in any of the previous claims, wherein said digital codes comprise amplitude information of said summed main output signal and auxiliary output signal.

8. Digital power amplification circuit as in as in any of the previous claims, comprising a plurality of upsampling means (4,14) and a plurality of auxiliary digital power amplifiers (6,16).

9. Digital power amplification circuit as in claim 8, wherein each upsampling means is operable at its own upsampling factor.

10. Digital power amplification circuit as in as in any of the previous claims, wherein said digital codes are modulated with a clock signal comprising phase information.

11. Radio device comprising a digital power amplifier as in any of the previous claims.
